# EUROPEAN PATENT APPLICATION

(11) **EP 1 543 946 A1**
(43) Date of publication of application: **22.06.2005**
(21) Application number: 04029917.4
(22) Date of filing: 16.12.2004
(51) Int. Cl.: B32B 3/16, B32B 7/06, B32B 7/12, G02B 1/10, G02B 1/11, C23C 24/02, G02B 5/00, C08J 7/04, C09J 7/02

(54) **Transfer functional film, method for forming functional layer and object to which functional layer is applied**

(30) Priority: 17.12.2003 JP 2003419073
(71) Applicant: TDK Corporation, Tokyo 103-8272 (JP)
(72) Inventor: Iijima, Tadayoshi TDK Corporation, Tokyo 103-8272 (JP)
(74) Representative: Grünecker, Kinkeldey, Stockmair & Schwanhäusser Anwaltssozietät

(57) **Abstract**

A transfer functional film having on a substrate 1 at least a functional layer 4 which can be separated from the substrate 1, the functional layer 4 being a compressed layer of functional fine grains, and having on the functional layer 4 an adhesive layer 5 made up of an adhesive composition containing a curing component (A) and a polyester polyurethane resin (P). A method for forming a functional layer on a surface of an object comprising the steps of affixing the transfer functional film on a surface of an object to which a functional layer is to be applied via the adhesive layer 5 in such a manner that the substrate 1 is positioned outside, causing the adhesive layer 5 to cure after the affixation, and separating the substrate 1.

## Description

### BACKGROUND OF THE INVENTION

### Field of the Invention

The present invention relates to a transfer functional film having a functional layer made up of a compressed layer of functional fine grains on a substrate, a method for forming a functional layer on a surface of an object and an object in which a functional layer is applied to a surface thereof. In the invention, the functional film includes both a functional film and a functional sheet.

The functional layer means a layer having a function, and the function means an action attained through physical and/or chemical phenomena. The functional layer includes layers having various types of functions such as a conductive layer, ultraviolet shielding layer, infrared shielding layer, magnetic layer, ferromagnetic layer, dielectric layer, ferroelectric layer, electrochromic layer, electroluminescence layer, insulating layer, photo absorbing layer, photo selective absorbing layer, reflecting layer, reflection preventive layer, catalyst layer and photocatalyst layer.

Above all, the invention relates to a transfer functional film having a transparent conductive layer, a method for forming a transparent conductive layer on a surface of an object and an object in which a transparent conductive layer is applied to a surface thereof. In addition to an application to a transparent electrode such as a plasma display panel electrode, electroluminescence element electrode, liquid crystal electrode, transparent surface exothermic body, and a touch panel, the transparent conductive layer can be used as a transparent electromagnetic wave shielding layer.

### Background of the Invention

Conventionally, functional layers made up of various types of functional materials are produced by a physical vapor deposition (PVD) such as a vacuum evaporation, laser abrasion, spattering and ion plating, as well as a chemical vapor deposition (CVD) such as a thermal CVD, photo CVD and plasma CVD. In general, these vapor depositions require a large-scale system, and some of the vapor depositions are not suitable for forming a film of a large area.

For example, currently, transparent conductive layers are produced mainly by using the spattering process. The spattering process is superior in that the process can produce a conductive layer of a relatively large area which has a lower surface electric resistance. However, the spattering process has drawbacks that the system becomes large-scale and that the film forming speed is slow.

A production of transparent conductive layers using a coating process has also been attempted. In a conventional coating process, a conductive coating material in which conductive fine grains are dispersed in a binder solution is coated on a base, and the coating material so coated is then dried and cured to form a conductive layer. The coating process has advantages that a conductive layer of a large area can easily be formed, that the system can be simple and the high productivity can be attained and that conductive layers can be produced at lower costs than when produced using the spattering process. In the coating process, an electric path is formed by virtue of contacts between conductive fine grains to thereby generate conductivity. However, the conventional coating process has a drawback that the contact is insufficient in conductive layers produced using the conventional coating process, so that the electric resistance value of the conductive layers so obtained becomes high (the conductivity becomes lower), and this limits the application thereof.

For example, JP-A-8-199096 discloses as a coating process which uses no binder resin a process in which a conductive layer forming coating material which consists of tin-doped indium oxide (ITO) powder, solvent, coupling agent and metallic organic acid salt or metallic inorganic acid salt and which contains no binder is coated an a glass plate, and the coating material is fired at a temperature of 300°C or higher. In this process, since no binder is used, the electric resistance value of the conductive layer becomes low.

In addition, a film forming process using a sol-gel process is also known. The coating process using the sol-gel process is suitable for forming a film of a large area.

In any of the coating processes, however, while a functional layer of a large area can easily be formed in the event that the substrate is something like a film which has a flexibility, in the event that the substrate is something like a plate which is poor in flexibility, coating becomes difficult when compared with the coating on the flexible substrate, and in particular, it is difficult to control uniformly the thickness of a film.

JP-A-6-103839 discloses a method for producing a transparent conductive base by transfer.
[Patent Literature No. 1] JP-A-8-199096
[Patent Literature No. 2] JP-A-6-103839
[Patent Literature No. 3] JP-A-2002-347150

The inventor of the present invention proposed in JP-A-2002-347150 a transfer functional film having a functional layer provided using the coating process to exhibit a certain function such as a transparent conductive layer of a low electric resistance value which is designed to apply a functional layer of a uniform thickness to an object such as a plate material which is poor in flexibility, an object to which the functional layer is applied, and a method for producing the object to which the functional layer is applied. The functional layer was such as to be made up of a compressed layer of functional fine grains which was formed on a substrate in such a manner as to be separable from the substrate, and the functional layer is superior in exhibiting the designed function. For example, in a case where conductive fine grains are used as the functional fine grains, the functional layer is superior in conductivity.

When transferring the functional layer onto a surface of an object to which the transfer is attempted to be made using the transfer functional film, an adhesive layer is interposed between the surface of the object and the functional layer so as to affix them together, the adhesive layer is cured, and thereafter, a substrate of the transfer functional film is separated. Incidentally, depending upon an object to which a functional layer is to be applied, there exists a case where the adhesion between the surface of the object and the adhesive layer is not as good as intended. In such a case, an adhesion facilitating layer (an adhesion facilitating treatment) for enhancing the adhesion to the adhesive layer needs to be formed in advance on the surface of the object. For example, in a case where the object to which the transfer is attempted to be made is made from a PET (polyethylene terephthalate) material, it is generally accepted that the adhesion between the surface of the PET material and the adhesive layer is not relatively good. Consequently, an adhesion facilitating layer needs to be formed in advance on the surface of the PET material. There are various types of PET films or sheets depending upon types and amounts of fillers that are contained in the films or sheets and film producing conditions. Some of them have no adhesion facilitating layer.

In addition, even in a case where the PET material having the adhesion facilitating layer is used, there were cases where the following drawbacks were generated. For example, let's consider a case where a film is prepared which has a hard layer on one side and a transparent conductive layer on the other side thereof. In this case, it is considered that using a PET film having an adhesion facilitating layer formed on one side thereof, which is relatively easy to be obtained, firstly, a corona discharge treatment is applied to a side of the PET film which is opposite to the adhesion facilitating layer thereof, thereafter, a silicone hard layer is formed on the surface to which the corona discharge treatment was applied, and following this, a transparent conductive layer is formed on the adhesion facilitating layer by transfer. To form the silicone hard layer, a liquid for the hard layer is applied to the surface of the PET film and is then dried, the film is taken up into a roll, and furthermore, the film so taken up is cured thermally. As this occurs, the silicone hard layer material which has not yet been cured is brought into contact with the adhesion facilitating layer in the rolled state, and they come to adhere to each other during thermosetting. This used to result in a case where the film is broken, when the rolled-up film is attempted to be unrolled. In contrast to this, in the event that a PET film is used on which no adhesion facilitating layer is formed, since the adhesion between the silicone hard layer material and the surface of the PET film is bad, a drawback such as described above does not occur.

From the background described above, a transfer functional film is desired which can apply various types of functional layers to the surface of an object with good adhesion by transfer, even in a case where no adhesion facilitating layer is formed on the surface of the object.

### SUMMARY OF THE INVENTION

An object of the invention is to provide a transfer functional film for applying a functional layer having a uniform thickness and a high function to a surface of even an object which is poor in flexibility as in a plate and in which no adhesion facilitating layer is formed on the surface thereof. In addition, another object of the invention is to provide a method for forming a functional layer on a surface of an object. Furthermore, a further object of the invention is to provided an object in which a functional layer is applied to a surface thereof.

Above all, an object of the invention is to provide a transfer conductive film for applying with good adhesion a transparent conductive layer having a uniform thickness and a lower electric resistance value to a surface of even an object which is poor in flexibility as in a plate and in which no adhesion facilitating layer is formed on the surface thereof. In addition, another object of the invention is to provide a method for forming a conductive layer on a surface of an object. Furthermore, a further object of the invention is to provide an object in which a conductive layer is applied to the surface thereof.
The aforesaid problem could be solved by utilizaing an adhesive composition containing a curing component (A) and a polyester polyurethane resin (P).

### BRIEF DESCRIPTION OF THE DRAWINGS

Figs. 1A to 1C are views explaining modes of separation;
Fig. 2 is a sectional view showing an example of a transfer functional film of the invention;
Fig. 3 is a sectional view showing another example of the invention;
Fig. 4 is a sectional view showing an example of an object to which a functional layer of the invention is applied; and
Figs. 5A to 5C are views explaining separations that occur when a transfer is implemented using the transfer functional films of the invention.

### DETAILED DESCRIPTION OF THE PREFERRED EMBODIMENTS

The invention includes the following inventions.

(1) A transfer functional film having on a substrate at least a functional layer which can be separated from the substrate, the functional layer being a compressed layer of functional fine grains, and having on the functional layer an adhesive layer made up of an adhesive composition containing a curing component (A) and a polyester polyurethane resin (P). The substrate has a flexibility.

The compressed layer of functional fine grains can be obtained by compressing a layer containing functional fine grains satisfying a desired application which layer is formed by applying a liquid in which the functional fine grains are dispersed is applied to the substrate and is then dried. The compressed layer of the functional fine grains is preferably such as to be obtained by being compressed by a compression force of 44N/mm² or greater.

To obtain the transfer conductive film, conductive fine grains are used as the functional fine grains. Namely, a compressed layer of conductive fine grains can be obtained by compressing a layer containing conductive fine grains which is formed by applying a liquid in which the conductive fine grains are dispersed is applied to the substrate and is then dried. The compressed layer of the conductive fine grains is preferably such as to be obtained by being compressed by the compression force of 44N/mm² or greater.

In producing the transfer conductive film, in order to obtain a conductive layer having a lower electric resistance value, while the dispersion of conductive fine grains may contain a small amount of resin, the dispersion preferably contains, in particular, no resin. In the event that the dispersion of conductive fine grains contains resin, the contents of resin are preferably less than 25, when the volume of the conductive fine grains is expressed as 100.

Also in producing other transfer functional films than the transfer conductive film, in order to obtain a functional layer having a higher function, while the dispersion of functional fine grains may contain a small amount of resin, the dispersion preferably contains, in particular, no resin.

(2) A transfer functional film as set forth in (1), wherein the adhesive composition contains an acrylic monomer (M) as the curing component (A).

(3) A transfer functional film as set forth in (1) or (2), wherein the adhesive composition contains the polyester polyurethane resin (P) and the acrylic monomer (M) in a weight ratio of P/M=2/8 to 8/2.

(4) A method for forming a functional layer on a surface of an object comprising the steps of affixing the transfer functional film set forth in any of (1) to (3) on a surface of an object to which a functional layer is to be applied via the adhesive layer in such a manner that the substrate is positioned outside, causing the adhesive layer to cure after the affixation, and separating the substrate.

(5) A method for forming a functional layer on a surface of an object as set forth in (4), wherein the surface of the object to which a functional layer is to be applied is not treated to exhibit easy adhesiveness.

(6) A method for forming a functional layer on a surface of an object comprising the steps of:
preparing a transfer functional film having on a substrate at least a functional layer which can be separated from the substrate, the functional layer being a compressed layer of functional fine grains;
providing in advance an adhesive layer made up of an adhesive composition containing a curing component (A) and a polyester polyurethane resin (P) on a surface of an object to which a functional layer is to be applied;
affixing the transfer functional film via the adhesive layer provided in advance on the surface of the object in such a manner that the substrate is positioned outside, causing the adhesive layer to cure after the affixation, and separating the substrate.

In (6), the adhesive composition preferably contains an acrylic monomer (M) as the curing component (A) . In addition, the adhesive composition preferably contains the polyester polyurethane resin (P) and the acrylic monomer (M) in a weight ratio of P/M=2/8 to 8/2.

(7) An object in which a functional layer is applied to a surface thereof, having an adhesive layer made up of a cured material of an adhesive composition containing a curing component (A) and a polyester polyurethane resin (P) on a surface thereof and having a functional layer on the cured adhesive layer.

(8) An object in which a functional layer is applied to a surface thereof as set forth in (7), wherein the functional layer is a compressed layer of functional fine grains.

(9) An object in which a functional layer is applied to a surface thereof as set forth in (8), wherein the adhesive composition containing the curing material (A) and the polyester polyurethane resin (P) is impregnated and cured in voids among the functional fine grains in the functional layer.

In (7) to (9), the adhesive composition preferably contains an acrylic monomer (M) as the curing component (A). In addition, the adhesive composition preferably contains the polyester polyurethane resin (P) and the acrylic monomer (M) in a weight ratio of P/M=2/8 to 8/2.

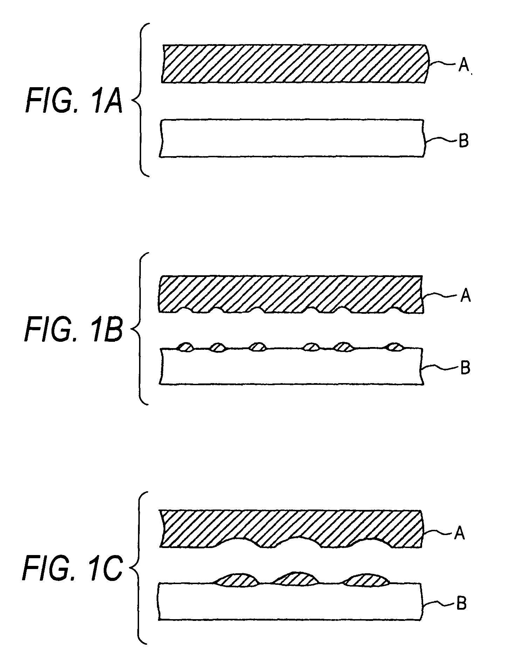

When used in the specification, a term, separable, contains cases shown in Fig. 1.
Fig. 1A is a mode of separation which is normally understood as separation and in which a layer A and a layer B which are in contact with each other are completely separated from an interface therebetween.
Figs. 1B and 1C are modes of separation in which while a layer A and a layer B are separated from an interface therebetween, part of the layer A remains on the layer B. Thus, even if separation is not as complete as the separation shown in Fig. 1A when observing it microscopically, in case each layer substantially constitutes a layer after separation, they are understood as separable. In the case of the invention, the functional layer includes a layer corresponding to the layers A in Figs. 1B and 1C.

In addition, in the invention, "a substrate is a separable functional layer" or "a functional layer separable from a substrate" means that the substrate and the functional layer are in a state where they are separable from each other. When the transfer functional film of the invention is put into an actual use, in many cases, the substrate is separated from the functional layer which is affixed to the surface of the object via an adhesive layer.

In the transfer functional film of the invention, it is also preferable to have an intermediate layer between the substrate and the functional layer in order to facilitate the separation of the functional layer from the substrate when a transfer is implemented.

In the invention, there is a case where the functional layer is patterned after transfer.

The adhesion between the adhesive layer and the surface of the object becomes good by containing the polyester polyurethane resin (P) in the adhesive composition even if no adhesion facilitating layer is formed on the surface of the object. As a result, a strong adhesion between the functional layer and the surface of the object can be obtained via the adhesive layer.

Thus, according to the invention, a transfer functional film is provided which can attain the application of a functional layer having a uniform thickness and a high function to the surface of an object on which no adhesion facilitating layer is formed with good adhesion by transfer. In addition, according to the invention, a method is provided for forming a functional layer on the surface of an object. Furthermore, according to the invention, an object is provided in which a functional layer is applied to the surface thereof.

Preferred embodiments of the present invention will be described hereinafter.
Firstly, a transfer functional film (hereinafter, simply referred to as a functional film) of the invention will be described below.

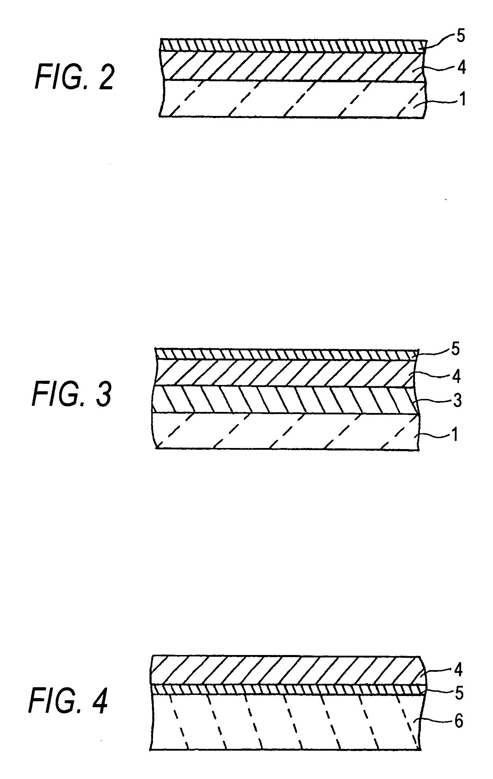

Fig. 2 is a sectional view showing an example of a layer constitution of a functional film in which a functional layer 4 is formed on a substrate 1, and an adhesive later 5 is formed on the functional layer 4.

In the invention, the functional layer 4 includes, with no specific limitation, layers having various types of functions such as a conductive layer, ultraviolet shielding layer, infrared shielding layer, magnetic layer, ferromagnetic layer, dielectric layer, ferroelectric layer, electrochromic layer, electroluminescence layer, insulating layer, photo absorbing layer, photo selective absorbing layer, reflecting layer, reflection preventive layer, catalyst layer and photocatalyst layer. Consequently, in the invention, functional fine grains are used which are suitable for the constitution of a target layer among the aforesaid functional layers. As the functional fine grains, with no specific limitation, inorganic fine grains are mainly used which have an aggregation force. In the invention, also in producing any of the aforesaid functional layers, by adopting a coating and compressing forming method which will be described below, a functional layer having a sufficient mechanical strength can be obtained, and adverse effects can be eliminated which would otherwise be caused by a binder resin which is used in a large amount in the conventional coating method. As a result, the function aimed to take place can be enhanced further.

For example, in producing transparent conductive layers, conductive inorganic fine grains such as tin oxide, indium oxide, zinc oxide, cadmium oxide, antimony-doped tin oxide (ATO), fluorine-doped tin oxide (FTO), tin-doped indium oxide (ITO), and aluminum-doped zinc oxide (AZO) are used. ITO is preferred in that it is superior in conductivity. Alternatively, a conductive layer can also be used in which an inorganic material such as ATO or ITO is coated on the surface of fine grains such as barium sulfate having transparency. The grain size of these fine grains differs depending on the needed degree of scattering which is determined by the application of a conductive film after completion, and although it is not possible to generalize due to the shapes of grains, a grain size of 10µm or smaller is generally used, a grain size of 1.0µm or smaller is preferred, and a grain size of 5nm to 100nm is more preferred.

In producing ferromagnetic layers, iron oxide magnetic powder such as γ-Fe₂O₃, Fe₃O₄, Co-FeOx and Ba ferrite, and ferromagnetic alloy powder containing as a main component a ferromagnetic metallic element such as α-Fe, Fe-Co, Fe-Ni, Fe-Co-Ni, Co and Co-Ni are used. The saturated magnetic flux density of a magnetic layer is enhanced.

In producing dielectric or ferroelectric layers, dielectric or ferroelectric fine grains such as magnesium titanate, barium titanate, strontium titanate, lead titanate, lead zirconate titanate (PZT), lead zirconate, lead lanthanum-added zirconate titanate (PLZT) , magnesium silicate, and lead-containing perovskite compound are used. By adoption of this production method, dielectric properties or ferroelectric properties can be enhanced.

In producing metallic oxide layers which exhibit the respective functions, metallic oxide fine grains such as iron oxide (Fe₂O₃), silicone oxide (SiO₂), aluminum oxide (Al₂O₃), titanium dioxide (TiO₂) , titanium oxide (TiO), zinc oxide (ZnO), zirconium oxide (ZrO₂) and tungsten oxide (WO₃) are used. By adoption of this production method, since the degree of packing of metallic oxide in a layer is increased, for example, in a case where WO₃ is used, the color development action in an electrochromic display element can be enhanced.

In addition, in producing electroluminescence layers, zinc sulfide (Zns) fine grains are used. By adoption of this production method, the production of inexpensive electroluminescence layers by the coating process can be attained.

In the invention, a liquid in which functional fine grains selected from the aforesaid various types of functional fine grains in accordance with the application of a completed layer are dispersed is used as a functional coating material. This functional coating material is coated on a substrate or an intermediate layer provided on the substrate and is then dried to thereby form a layer containing the functional fine grains so selected. Thereafter, the functional fine grains-containing layer is preferably compressed to thereby form a compressed layer of the functional fine grains.

As liquids in which functional fine grains such as conductive fine grains are dispersed, various types of known liquids can be used with no specific limitation. For example, saturated hydrocarbons such as hexane, aromatic hydrocarbons such as toluene and xylene, alcohols such as methanol, ethanol, propanol and butanol, ketones such as acetone, methyl ethyl ketone (MEK), methyl isobutyl ketone and diisobutyl ketone, esters such as ethyl acetate and butyl acetate, ethers such as tetrahydrofuran, dioxane and diethyl ether, amides such as N, N-dimethylformamide, N-methyl pyrrolidone (NMP), N, N-dimethyl acetamido, and halogenated hydrocarbons such as ethylene chloride and chlorobenzene can be raised as liquids. Among them, a liquid having a polarity is preferred, and in particular, alcohols such as methanol and ethanol and amides such as NMP have affinity for water and are preferred since they have good dispersibility without using a dispersant. These liquids can be used as alone or in combination. In addition, dispersants can be used depending on the types of liquids.

In addition, water can be used as a liquid. When water is used, the surface of a resin layer needs to have a hydrophilic nature. Since resin films and resin layers normally have a hydrophobic nature, water tends to be repelled therefrom and it is difficult to obtain a uniform layer. In this case, alcohol needs to mixed with water or a corona discharge treatment needs to be applied to the surface of a resin layer so as to produce a hydrophilic nature therein.

There is no specific limitation on the amount of liquid used, and the amount of liquid may be determined such that the dispersion of fine grains have a viscosity suitable for coating. For example, a suitable amount of liquid is of the order of 100 to 100, 000 parts by weight per 100 parts by weight of the fine grains. The amount of liquid may be selected appropriately depending on types of fine grains and liquid.

The dispersion of the fine grains in liquid may be implemented using known dispersion processes. For example, the dispersion is implemented using a sand grinder mill process. In implementing a dispersion, in order to relax the aggregation of fine grains, a medium such as zirconia beads may preferably be used. In addition, in implementing a dispersion, cares have to be taken so as to prevent the inclusion of impurities such as dust.

The dispersion of fine grains preferably contains no resin. Namely, it is preferred that the amount of resin is zero. In the event that no resin is used in a conductive layer, there is no risk that the contact between conductive fine grains is disturbed by resin, and the volume packing of fine grains is increased. Consequently, the conductivity between the conductive fine grains is secured, and the electric resistance value of a conductive layer obtained is decreased. While resin can be contained in an amount that does not damage the packing properties, an upper limit of the resin contents in the dispersion is, for example, when represented as volume before dispersion, less than 25 by volume when the volume of the conductive fine grains is represented as 100.

Also in functional layers using WO₃ fine grains or TiO₂ fine grains, in case no resin is used, since there is no risk that the contact between respective fine grains is disturbed by resin, the designed function can be attempted to be enhanced. While resin can be contained in such an amount that neither disturbs the contact between fine grains nor damages the designed function, the amount of fine grains so contained is, for example, about 80 or smaller by volume when the volume of the relevant fine grains is represented as 100.

Thus, it is preferable to use no or, when used, a small amount of resin in a functional layer at the time of compression (namely, in the dispersion of fine grains). Since the amount of resin, when it is really used, can vary to some extent depending on the purpose of application of a functional layer so formed, the amount may be determined appropriately.

Various types of additives may be formulated into the dispersion of fine grains within a range where performances required for the respective functions such as conductivity and catalytic action are satisfied. For example, the additives include ultraviolet absorbing agents, surfactants and dispersing agents.

Flexible resin films which do not break even if the compression force is increased during a compression process are preferred as the substrate 1. The resin films are light in weight and easy to be handled. In the invention, in producing transfer conductive films, since there exists neither a pressurizing process at high temperatures nor a firing process, resin films can be used as the substrate.

As resin films, for example, polyester films such as polyethylene terephthalate (PET), polyolefin films such as polyethylene and polypropylene, polycarbonate films, acrylic films and norbornene films (ATONE produced by JSR Co., Ltd.) can be raised. In addition to the resin films, cloth and paper can also be used.

In the case of the conductive film whose layer constitution is shown in Fig. 2, a separation treatment may be applied to a surface of the substrate 1 on which the functional layer 4 is to be formed as required in order to produce a state in which the functional layer 4 so formed can be separated from the substrate 1. For example, a silicone separating agent or the like may be applied to the surface of the substrate.

The dispersion of functional fine grains is applied to the substrate 1 and is then dried to thereby form a functional fine grains-containing layer.

The application of the dispersion of fine grains can be implemented using known methods with no specific limitation. For example, coating processes can be used which includes a reverse roll coating process, direct roll coating process, blade coating process, knife coating process, extrusion nozzle coating process, curtain coating process, gravure roll coating process, bar-layer coating process, dip coating process, kiss-layer coating process and squeeze coating process. In addition, the dispersion can be made to adhere to the substrate by atomization, spray or the like.

Although depending on types of liquids used in the dispersion, the drying temperature is preferred to be in a range of 10 to 150°C. Condensation of water contained in the air tends to take place at a temperature less than 10°C, whereas, when the temperature exceeds 150°C, the resin film substrate itself deforms. In addition, cares have to be taken in order to prevent the adhesion of impurities to the surface of the fine grains at the time of drying.

Although depending on compressing conditions at the following process, as well as the application of the relevant functional layer such as a final conductive film, the thickness of a functional fine grains-containing layer such as the conductive fine grains-containing layer may be on the order of 0.1 to 10µm.

Thus, it is easy to form a uniform layer by dispersing the functional fine grains such as the conductive fine grains in liquid, applying the dispersion so formed to the substrate, and causing the dispersion so applied to be dried. When the dispersion of fine grains is coated and is then dried, even in the event that there exists no binder in the dispersion, the fine grains so dispersed form a layer. While there is available no clear reason why the layer is formed with no binder existing in the dispersion, the fine grains come to get together due to a capillary force when the liquid is decreased by being dried. Furthermore, since being fine grains is considered to increase the specific surface area and to produce a strong aggregation force, the liquid can forma layer. However, generally speaking, the strength of the layer at this stage is low. In addition, in the conductive layer, the resistance value of the layer is high and the resistance value varies largely.

Then, it is preferred to compress the functional fine grains-containing layer such as the conductive fine grains-containing layer so formed to thereby obtain the compression layer (4) of functional fine grains such as conductive fine grains. The strength of the layer is enhanced by compression. Namely, contact points between functional fine grains such as conductive fine grains are increased to thereby increase the contact surface by compression. Due to this, the layer strength is increased. Since fine grains originally tend to aggregate, they form a strong layer by being compressed.

In the conductive layer, by being compressed, the strength of the layer is increased and the electric resistance is decreased. Namely, contact points between conductive fine grains are increased to thereby increase the contact surface by being compressed. Due to this, the layer strength is increased and the electric resistance is decreased.

In other functional layers, a highly strong layer in which fine grains are linked to one another can be attained, and since no or only a small amount of resin is used, the packing amount of fine grains per unit volume is increased. Due to this, respective designed functions can be attained to a higher extent.

The compression is preferably implemented by a compression force of 44N/mm² or greater. With a lower compression force of less 44N/mm² than, the functional fine grains-containing layer cannot be compressed sufficiently, and, for example, a conductive layer superior in conductivity is difficult to be obtained. The compression force is preferably 135N/mm² or greater, and a compression force of 180N/mm² is more preferable. The layer strength is increased as the compression force becomes higher, whereby the adhesion to the substrate is enhanced. In the conductive layer, the strength is increased, whereby a layer more superior in conductivity can be obtained. Since the pressure resistance of the apparatus has to be increased as the compression force becomes higher, in general, a compression force of not greater than 1000N/mm² is appropriate.

In addition, it is preferable to implement the compression at temperatures at which the substrate is not deformed. For example, in a case where the substrate is made up of a resin film, the temperatures fall within a range located as high as or lower than the glass transition temperature (a secondary transition temperature) of the resin used.

While the compression can be implemented using sheet pressing, roll pressing or the like with no specific limitation, it is preferable to use a roll press machine to carry out the compression. The roll pressing is a process in which a film to be compressed is inserted between rolls, and then the rolls are caused to rotate. In the roll pressing, a high pressure is applied uniformly, and hence the roll pressing process is more productive than the sheet pressing process, the roll pressing process being preferred to the sheet pressing process.

From the perspective of productivity, the roll temperature of the roll press machine is preferably at normal temperatures (an environment where human beings are easy to work) . In a heated atmosphere or compression using heated rolls (hot pressing) , in the event that the compression pressure is increased, a drawback is caused that a resin film is extended. In order to prevent the elongation of a resin film under a heated environment, when the compression pressure is decreased, the mechanical strength of the conductive layer is decreased, whereby the electric resistance is increased. When the roll press machine is used for continuous compression, it is also preferable to adjust the temperature of the rolls so as not to be increased by heat generated from the rolls due to the continuous compression.

When the amount of water that adheres to the surface of fine grains needs to be reduced for some reason, while the atmosphere may be heated in order to reduce the relative temperature of the atmosphere, the temperature of the atmosphere should fall within a range where the easy elongation of the film is prevented. In general, such a range of temperatures should be not greater than the glass transition temperature (the secondary transition temperature). The temperature may be set to a temperature which is slightly higher than a required temperature in consideration of variation in temperature.

Note that the glass transition temperature of a resin film is obtained by measuring the dynamic viscoelasticity thereof and indicates a temperature at which the dynamic loss of a main dispersion reaches its peak. For example, when observing as to a PET film, the glass transition temperature thereof is substantially around 110°C.

A metallic roll is preferably used as a roll of the roll press machine as a strong pressure is applied thereto. In addition, since there occurs a case where fine grains are transferred or caused to adhere to the surface of the roll during compression, in the event that the surface of the roll is soft, it is preferable to treat the surface of the roll so as to provide thereon a layer sprayed with hard chrome or ceramics, a layer ion-plated with TiN, a hard layer of DLC (diamond-like carbon) or the like. In addition, in order to prevent the occurrence of a transfer or adhesion of fine grains to the surface of the roll, it is preferable to perform a compression with a transfer preventive film being interposed between the roll positioned on the functional fine grains-containing layer side and the functional fine grains-containing layer. It is preferable that a hard layer treatment is provided on the side of the transfer preventive film which faces the fine grains-containing layer in order to make it difficult for the fine grains to adhere thereto.

In addition, the compressed layer of functional fine grains may be formed using a transfer forming method described in JP-A-2003-1783. Namely, a functional fine grains-containing layer is formed on a hard layer side of a resin film where a hard layer is provided. This resin film and a substrate on which a compressed layer is to be formed are superposed on each other for compression in such a manner that the functional fine grains-containing layer and the substrate are brought into contact with each other, whereby a compressed layer of functional fine grains is transfer formed on the substrate. After compression, the resin film is separated.

Thus, the compressed layer of functional fine grains such as conductive fine grains is formed. Depending on applications, the thickness of the compressed layer of functional fine grains may be on the order of 0.1 to 10µm. In addition, in order to obtain a thick compressed layer of a thickness of on the order of 10µm, the series of processes of applying a dispersion of fine grains, drying the same and compressing the fine grains-applied layer may be repeated. Furthermore, in the invention, it is, of course, possible to form the functional layer on both sides of the substrate.

In the invention, the compressed layer of functional fine grains may be made up of at least two compressed layers of different functional fine grains. Depending on the purpose and/or application of a multi-coated functional layer, a multi-coated constitution may be provided by combining a plurality of functional layers having different functions. By combining a plurality of functional layers, a multi-coated functional layer can be obtained which can be applied, for example, to solar cells, electroluminescence elements and electrochromic elements. The multi-coated constitution can be obtained by repeating the series of processes of applying a dispersion of fine grains which corresponds to the function of a layer to be formed, drying the same and compressing the fine grains-applied layer. Not all the respective layers which make up the multi-coated constitution need to be a compressed layer. For example, when applied to solar cells, a transparent conductive layer, a transparent insulation layer and a semi-conductor layer may be formed by compression, and a metallic electrode may be formed by vapor deposition.

Thus, the functional layer 4 made up of the compressed layer of functional fine grains is formed.

In the transfer functional film of the invention, the adhesive layer 5 made up of an adhesive composition containing a curing component (A) and a polyester polyurethane resin (P) is formed on the functional layer 4.

As adhesive compositions that are used for the adhesive layer 5, adhesives are preferred which can obtain a tacky adhesive layer only by coating an adhesive solution and drying the same and which can obtain a hard cured layer by causing the adhesive layer to cure by a ray of activation energy such as a ultraviolet ray after the adhesive layer has been affixed to an object to which a transfer is attempted to be made.

By containing the polyester polyurethane resin (P) in the adhesive composition, an initial tackiness can be obtained, and a good adhesion can be attained between the adhesive layer and the surface of the object, even in the event that an adhesion facilitating layer is not formed on the surface thereof.

The following two points are considered as reasons why the containment of the polyester polyurethane resin (P) in the adhesive layer 5 can improve the adhesion. Firstly, the polyurethane is naturally soft. Due to the nature thereof, flexibility can be imparted to the adhesive layer by incorporating polyester polyurethane in the adhesive, whereby the drapeability to the object can be improved, thereby making it possible to improve the adhesion. Next, the polyester interacts well with the object, and in particular, the PET material has an ester-bonding, and both the PET material and polyester polyurethane have the homogeneous bonding referred to as the ester-bonding. Since a strong interaction occurs between homogeneous materials, the adhesion is considered to be improved. Thus, polyester polyurethane has the qualities of both polyester and polyurethane, and due to this, it is considered that a rigid adhesion can be obtained between the adhesive layer and the surface of the object.

The adhesive composition preferably contains an acrylic monomer (M) as the activation energy ray curing component (A) . In addition, the adhesive composition preferably contains polyester polyurethane resin (P) and the acrylic monomer (A) as solid contents in a weight ratio of P/M=2/8 to 8/2. By formulating like this, an adhesive layer can be formed which cures by being irradiated by a ray of activation energy while providing an appropriate tackiness. In the event that P/M becomes larger than 8/2, the initial tackiness tends to be reduced, whereas in the event that P/M becomes smaller than 2/8, the viscosity of the adhesive composition solution becomes too low, and there maybe a case where a drawback occurs when affixed.

Known materials can be used as the polyester polyurethane resin (P) , and for example, VYLON UR1400, UR2300, UR3200, UR8200, UR8300 and UR8700 (all are produced by TOYOBOSEKI Co., Ltd.) can be raised.

Known materials can be used as the acrylic monomer (M) , and for example, trifunctional or greater acrylic monomers such as KAYAR AD GPO-303, KAYARAD TMPTA, KAYARAD THE-330 (all are produced by NIHONKAYAKU Co., Ltd.) can be raised.

An epoxy monomer can be used as the activation energy ray curing component (A).

In addition, other polymeric resin than the polyester polyurethane resin (P) such as acrylic resin and cellulose resin may be contained in the adhesive composition for the sake of tackiness. Known materials can be used as the acrylic resin, and for example, acrylic resins 103B and 1BR-305 (both are produced by TAISEIKAKO Co., Ltd.) can be raised. As the cellulose resin, materials are preferred which contain an ester-bonding in part of its constitution. As ester, acetate, butyrate and propionate can be raised, and cellulose resins are used which contain one or two or more of the esters. To be specific, cellulose acetate butyrate (CAB; CAS No. 009004-36-8) and cellulose acetate propionate (CAP) can be raised. In the event that acrylic resins or cellulose resins are used, the amount of such resins to be added may be determined depending on applications.

Normally, a photopolymerization initiator is additionally contained in the adhesive layer. As photopolymerization initiator, various types of materials can be raised, and for example, KAYACURE DETX-S (produced by NIHONKAYAKU Co., Ltd.) can be raised. The amount of photopolymerization initiator may be on the order of 0.01 to 20wt% relative to the weight of the curing component. The productivity in causing the transfer functional film to adhere to the object is increased by curing the adhesive layer with a ray of activation energy such as ultraviolet ray. In addition, as the photopolymerization initiator, known materials may be used in which a photopolymerization initiator is added to an acrylic monomer. As the materials in which a photopolymerization initiator is added to an acrylic monomer, for example, an ultraviolet ray-curing resin SD-318 (produced by DAINIPPON INK KAGAKU KOGYO Co., Ltd.), XNR5535 (produced by NAGASE CHEMTEX Co., Ltd.) can be raised.

Additives such as ultraviolet absorbing agents and infrared absorbing agents or oligomers may be contained in the adhesive as required.

The adhesive layer surface may be protected until the transfer functional film is put into use by applying a separable film on the adhesive layer 5 of the transfer functional film of the invention.

The formation of the adhesive layer 5 can be implemented by applying an adhesive composition solution onto the functional layer 4. In addition, the adhesive layer 5 may be provided on the functional layer 4 by forming an adhesive layer on a separation substrate which is separately prepared and is treated so as to be separated as required and laminating the functional layer 4 on the substrate 1 with the adhesive layer in such a manner that the adhesive layer and the functional layer 4 are brought into contact with (adhesion to) each other. As this occurs, the separation substrate is applied onto the adhesive layer simultaneously with the formation of the adhesive layer 5, whereby the adhesive layer is protected until the transfer functional layer is put into use. Part of the adhesive is impregnated into the functional layer 4. Depending on the tackiness of the adhesive, the thickness of the adhesive may be set to on the order of 0.1µm to 100µm, and a thickness of 1µm to 20µm is preferable.

In the invention, it is preferred that after the formation of the compressed layer of functional fine grains, the compressed layer so formed is heated. By being heated, an internal stress generated when the compressed layer is formed is relaxed, and the corrosion resistance against the respective types of materials and solvents of the functional film is enhanced.

Conditions of the heating treatment may be selected appropriately. The temperature at which the heating treatment is performed is preferably 50°C or higher for the sake of relaxation of the internal stress, and 80°C or higher is more preferable. An upper limit value of the heating treatment temperature is 130°C for, for example, a case where a resin film is used on the substrate. As to the heating treatment time, a range of 1 minute to 100 hours is normal, a range of 10 minutes to 50 hours is preferable, and a range of 30 minutes to 25 hours is more preferable. As to the atmosphere during the heating treatment, the treatment may be performed under vacuum, under a reduced pressure, in the air, in nitrogen gas or in an inactive gas such as argon.

Thus, the transfer functional film of the invention can be prepared.

The transfer functional film of the invention includes two modes depending on whether or not the functional layer is exposed when transferred to the surface of the object to which a transfer is attempted to be made.

Transfer Functional Film of First Mode Where A Functional Layer is not Exposed:
A transfer functional film of a first mode is the transfer functional film in which an intermediate layer is formed on the substrate in such a manner as to be separated from the substrate, the functional layer is formed on the separable intermediate layer, and the separable intermediate layer can be separated from the substrate together with the functional layer. When the functional layer is transferred to the surface of the object to which a transfer is attempted to be made using the functional film of the first mode, the functional layer is transferred to the surface of the object, and the separable intermediate layer exists on the functional layer so transferred.

Transfer Functional Film of Second Mode Where A Functional Layer is Exposed:
A second transfer functional film of a second mode is the transfer functional film in which a primary layer is formed on the substrate, the functional layer is formed on the primary layer, and the functional layer can be separated from the primary layer.

The primary layer is a layer which is not substantially separated from the substrate when transferred. In other words, the transfer functional film of the second mode is the transfer functional film in which an intermediate layer is formed on the substrate in such a manner as not to be separated from the substrate and the functional layer can be separated from the substrate and the intermediate layer which is not separated.

When the functional layer is transferred to the surface of the object to which a transfer is attempted to be made using the functional film of the second mode, the functional layer is transferred to the surface of the object, and the functional layer so transferred is exposed. In the transfer functional film of the second mode, the primary layer or the intermediate layer that is not separated may be made up of a resin layer whose main component is resin.

Fig. 3 is a sectional view showing an example of the layer constitution of a functional film in which a resin layer 3, a functional layer 4 and an adhesive layer 5 are formed sequentially on a substrate 1 in that order. The resin layer 3 is the separable intermediate layer of the first mode or the primary layer or the intermediate layer that is not separated of the second mode. In the case of the first mode, a separation treatment is applied to the resin layer 3 side of the substrate 1, and a separation takes place between the substrate 1 and the resin layer 3 when transferred. In the case of the second mode, the adhesion between the substrate 1 and the resin layer 3 is high, and a separation takes place between the resin layer 3 and the functional layer 4 when transferred.

When the layer constitution shown in Fig. 3 illustrates the conductive film of the first mode, since the separation takes place between the substrate 1 and the resin layer 3 when transferred, a separation treatment may be applied to the resin layer 3 side of the substrate 1 due to the congeniality between a resin material making up the resin layer 3 and the substrate 1. The resin layer may be cured with heat or ultraviolet ray after compression.

When the layer constitution shown in Fig. 3 illustrates the conductive film of the second mode, since the separation takes place between the resin layer 3 and the functional layer 4 when transferred, it is preferred that the resin layer 3 has a relatively high hardness, for example, 2H or greater and 4H or smaller when expressed as pencil hardness. In addition, it is preferred that the adhesion between the substrate 1 and the resin layer 3 is high. A relatively hard resin can be used for the resin layer 3 of the second mode, and as such a resin, for example, a resin which can obtain a relatively high hardness can be used from acrylic resin, urethane resin, polyvinyl chloride resin and silicone resin. Fine grains such as silica can be contained in the resin layer for adjustment of the hardness.

The resin used for the resin layer 3 of the first and second modes may be such as not to be dissolved into a liquid in which the functional fine grains are dispersed. In the conductive layer, when the resin layer dissolves, a solution containing the resin is attracted to the periphery of the conductive fine grains due to the capillary phenomenon, and since this reduces the packing of fine grains, as a result, the electric resistance value of a conductive layer so obtained is increased. The thickness of the resin layer 3 is, for example, in the range of 0.005 to 20µm, and is preferably in the range of 0.01 to 5µm.

Next, the formation of a functional layer onto the surface of an object using a transfer functional film will be described.

As a transfer functional film, the transfer functional film of the invention that has been described heretofore can preferably be used. Alternatively, a similar film to the transfer functional film of the invention except that the film does not have the adhesive layer 5 can be used. In this case, an adhesive layer made up of an adhesive composition containing the aforesaid curing component (A) and polyester polyurethane resin (M) is provided in advance on the surface of an object to which a functional layer is to be applied.

Fig. 4 is a sectional view illustrating an example of a layer constitution in which a functional layer 4 is applied to the surface of an object 6 via an adhesive layer 5. Namely, Fig. 4 illustrates an example in which the functional layer 4 is transferred using the conductive film shown in Fig. 2 or the conductive film of the second mode shown in Fig. 3.

In order to obtain an object to which the functional layer of the invention is applied, the functional layer 4 of the functional film is transferred from the substrate 1 to the object 6. Namely, the functional film is affixed to the surface of the object 6 via the adhesive layer 5 of the film in such a manner that the substrate 1 is positioned outside, and after the affixation, the adhesive layer 5 is preferably cured with an ultraviolet ray, and thereafter, the substrate 1 of the film is separated. In the functional layer 4, since the adhesive composition is impregnated in voids between the functional fine grains, the adhesive so impregnated is also cured by virtue of the irradiation with the ultraviolet ray.

Alternatively, in the event that the adhesive layer 5 is not provided on the functional film, a similar adhesive to that for the adhesive layer 5 may be applied in advance to the surface of the object 6 before the transfer.

In any of the functional layer forming processes, since the polyester polyurethane resin (P) is contained in the adhesive composition, even in the event that no adhesion facilitating layer is formed on the surface of the object 6, a good adhesion is attained between the adhesive layer and the surface of the object. As a result, a strong adhesion is obtained between the functional layer and the surface of the object via the adhesive layer.

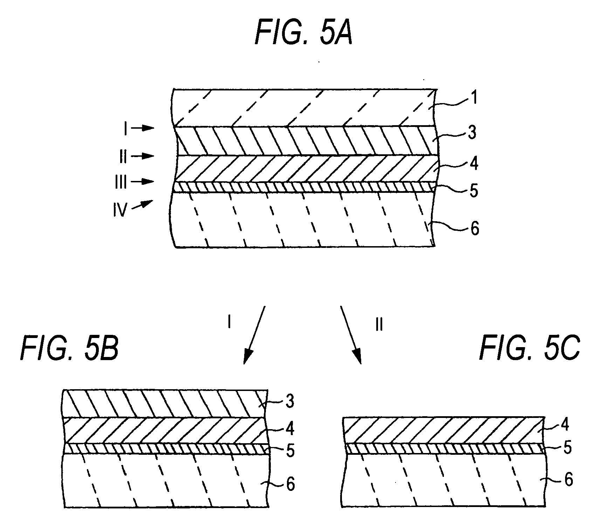

Fig. 5 is a drawing for explaining the separation taking place during transfer. Fig. 5A illustrates a state in which the functional film of the first mode or the second mode is affixed to the surface of an object to which a transfer is attempted to be made. Note that in the invention, such expressions as "separable" and "is not separated" are used to express behaviors taking place when a transfer is made to the object, as will be described below. Consequently, they are not such as to mean the absolute strength of adhesion.

The relationship among the respective layers of the invention will be described by taking Fig. 5 for example. As to the adhesion between a resin layer 3 and a functional layer 4, since part of functional fine grains of the functional layer 4 which in contact with the resin layer 3 is embedded into the resin layer 3 due to compression, the functional layer 4 is considered to adhere to the resin layer 3. Consequently, the adhesion between the two layers 3, 4 tends to be increased when the compression pressure is high, and when the resin layer 3 tends to be soft, the adhesion between the two layers 3, 4 becomes high. The adhesion,varies depending on the type, shape and grain size of the functional fine grains, and the adhesion also varies depending on whether or not there exists the resin which is contained in the layer of functional fine grains at the time of compression.

In Fig. 5, there exist an interface (referred to as an interface I) between a substrate 1 and the resin layer 3, an interface (referred to as an interface II) between the resin layer 3 and the functional layer 4, an interface (referred to as an interface III) between the functional layer 4 and an adhesive layer 5, and an interface (referred to as an interface IV) between the adhesive layer 5 and an object 6. In the invention, the invention of the first mode can be attained by making the adhesion at the interface I lower than adhesions at any other interfaces. In addition, the invention of the second mode can be attained by making the adhesion at the interface II lower than adhesions at any other interfaces.

In order to make the adhesion at the interface I lower than the adhesions at any other interfaces, the adhesion between the substrate 1 and the resin layer 3 may be made lower. To this end, in order that a separation takes place between the substrate 1 and the resin layer 3 when transferred, a separation treatment may be applied to the surface of the substrate 1 which faces the resin layer 3. In addition, the adhesions at the other interfaces may be increased. In order to increase the adhesion between the resin layer 3 and the functional layer 4, the resin layer may be made relatively soft.

In order to make the adhesion at the interface II lower than those at the other interfaces, the adhesion between the resin layer 3 and the functional layer 4 may be reduced. When the hardness of the resin layer 3 is made relatively high, the adhesion between the compressed layer and the resin layer is reduced. However, in the event that the resin layer 3 is made as hard as a hard layer, the adhesion is reduced excessively. In general, it is preferred that the resin layer 3 has a relatively high hardness of, for example, on the order of 2H to 4H when expressed by the pencil harness. In addition, the adhesions at the other interfaces may be increased. In order to increase the adhesion between the substrate 1 and the resin layer 3, an adhesion facilitating layer producing treatment (for example, a corona discharge treatment) may be applied to the surface of the substrate 1 so as to increase the adhesion thereat.

when separating the substrate 1, in the case of the functional film of the first mode, a separation takes place between the substrate 1 and the soft resin layer 3 (indicated by an arrow I in the drawing). The adhesion between the functional layer 4 and the soft resin layer 3 is good, and hence no separation takes place between the functional layer 4 and the resin layer 3. Consequently, as shown in Fig. 5B, the functional layer 4 is applied to the surface of the object 6 via the adhesive layer 5, and the resin layer 3 exists on the functional layer 4.

When separating the substrate 1, in the case of the functional film of the second mode, the adhesion between the functional layer 4 and the resin layer 3 being low, a separation takes place between the resin layer 3 and the functional layer 4 (indicated by an arrow II in the drawing) . Consequently, as shown in Fig. 5C, the functional layer 4 is applied to the surface of the object 6 via the adhesive layer 5, and the surface of the functional layer 4 is in an exposed condition. The functional film of the second mode is preferred when an exposed functional conductive layer is attempted to be applied to the surface of the object.

The functional film of the first mode or the second mode can be prepared by selecting a material and hardness mainly for the resin layer 3.

As the object 6 to which a transfer is attempted to be made, for example, plastic materials of PET or the like can be raised as for transparent conductive films for touch panels. In addition, as the object 6 to which a transfer is attempted to be made, plate-like, less flexible objects or substrates on which a layer of a uniform thickness is difficult to be formed, glass or ceramics on which a compressed layer is difficult to be formed directly and metallic objects are included with no specific limitation. In particular, in the invention, since the specific adhesive composition is used, there is provided an advantage that an adhesion facilitating treatment does not have to be applied to the surface of the object. As an example of the object, as has been described above, plastic materials of PET or the like can be raised.

### [Examples]

While the invention will be described in greater detail by reference to examples, the invention is not limited to the examples.

### [Embodiment 1]

As shown in Fig. 3, the transfer conductive film of the second mode in which the resin layer 3, the functional layer 4 and the adhesive layer 5 are formed sequentially on the substrate 1 in that order was prepared in the following procedure.

### (Preparation of Transfer Preventive Film for Preventing Transfer at the Time of Compression)

A corona discharge treatment was applied to a side of a PET film (T100-50 produced by MITSUBISHI CHEMICAL POLYESTER FILMS) having a thickness of 50µm such that the contact angle of pure water becomes 42°. A silicone hard layer liquid KP-854 (produced by SHINETSU KAGAKU KOGYOU Co., Ltd.) was applied to the side of the PET film to which the corona discharge treatment was applied, was dried and was cured at 70°C for 48 hours to thereby form a silicone hard layer of a thickness of 0.4µm. Thus, a transfer preventive film for preventing a transfer during compression was prepared in advance.

### (Formation of a Hard Resin Layer)

A corona discharge treatment was applied to a side of a PET film 1 (T100-50 produced by MITSUBISHI CHEMICAL POLYESTER FILMS) having a thickness of 50µm such that the contact angle of pure water becomes 42°. 100 parts by weight of liquid A, which is silicone solution, FRESERRA N-180 (produced by MATSUSHITA KOGYO) and 360 parts by weight of liquid B were mixed together to prepare a functional layer coating liquid. The coating liquid was applied to the corona discharged surface of the PET film 1, was dried and was cured at 70°C for 48 hours to thereby form a silicone resin layer 3 of a thickness of 0. 6µm.

### (Formation of Conductive Layer)

300 parts by weight of ethanol was added to 100 parts by weight of ITO fine grains, SUFP-HX (produced by SUMITOMO KINZOKU KOUZAN Co., Ltd.), whose primary grain size is in the range of 5 to 30nm and a mixture so formed was dispersed by a dispersing machine using zirconia beads as a medium. A coating liquid so obtained was coated on the resin layer 3 using a bar layerer and was then dried by blowing a hot air of 100°C. Hereinafter, a film so obtained is referred to as a pre-compression ITO film. The thickness of the ITO-containing layer was 1.7µm.

Firstly, a preliminary test was carried out for verification of a compression pressure.
The transfer preventive film and the pre-compression ITO film were overlaid on each other in such a manner that the hard layer surface of the transfer preventive film is brought into contact with an ITO surface of the pre-compression ITO film, and, using a roll press having a pair of metallic rolls of a diameter of 350mm (rolls whose surfaces are plated with hard chrome), the two films so overlaid were inserted between the rolls for compression at a room temperature (23°C) without rotating and heating the rolls. As this occurred, the pressure per unit length in the transverse direction of the film was 1100N/mm². Next, the pressure was relieved, and when investigating for the longitudinal length of the compressed portion of the film, it was 3.0mm. From this result, the compression was made with a pressure of 367N/mm².

Next, the transfer preventive film which is similar to that used in the preliminary experiment and the pre-compression ITO film were overlaid on each other, the two films so overlaid were then inserted between the metallic rolls for compression under the aforesaid conditions, and the rolls were rotated to thereby implement a compression at a feeding speed of 15m/min. As this occurred, the transfer preventive film and the pre-compression ITO film were separated from each other without being caused to adhere to each other when the films had passed through the rolls. Thus, a film having a compressed ITO layer on the hard resin layer (3) (the film being referred to as a compressed ITO film) was obtained. The thickness of the ITO compressed layer was 1.0µm.

### (Relaxation of Stress)

The compressed ITO film so obtained was left in an atmosphere in which the temperature was 50°C and a dew point was -40°C for 72 hours so as to relax the stress.

### (Formation of Adhesive Layer)

106 parts by weight of ultraviolet curing resin SD-318 (produced by DAINIPPON INK KAGAKU KOGYO Co., Ltd.) and 274 parts by weight of methyl ethyl ketone were added to 100 parts by weight of polyester polyurethane resin, UR1400 (solid contents density: 30wt% and produced by TOYOBOSEKI Co., Ltd.) to thereby prepare an adhesive layer coating liquid. The coating liquid so prepared was coated on the conductive layer 4 and was dried to thereby form the adhesive layer 5 of a thickness of 3.5µm. When touching the adhesive layer 5, a tackiness was felt. Thus, the transfer conductive film was obtained.

### (Transfer of Conductive Layer to PET Film)

The transfer conductive film so obtained was affixed by a laminator in such a manner as to be brought into contact with a PET film, HSL75 (75µm thick and produced by TEIJIN DUPONT), on which no adhesion facilitating layer was formed. The adhesive layer 5 was cured by irradiating the same with an ultraviolet ray, and after curing, the substrate PET film 1 was separated. The adhesive layer 5 was very rigid.

Thus, as shown in Fig. 4, the conductive layer 4 was applied onto the PET film 6 via the adhesive layer 5.

### (Electric Resistance)

When the electric resistance of the conductive layer 4 was measured using a non-contact resistance measuring apparatus (MODEL 717B produced by COPER ELECTONICS Co., Ltd.), it was 250Ω/□ (surface resistance) .

### (Adhesion Evaluation)

An adhesion performance test was carried out according to the grid opening tape method (JIS K5400). 11 cuts were cut with a cutter knife in the surface of the conductive layer 4 applied on the PET film 6 vertically and horizontally, respectively, at intervals of 1mm (in such a manner that in total 100 square cells were formed) . Adhesive cellophane tapes were affixed to and separated from the surface where the cuts were so made. All of the 100 cells remained.

### [Comparison Example 1]

In forming the adhesive layer, a transfer conductive film was prepared in the similar procedure to that of Embodiment 1 except that 140 parts by weight of ultraviolet curing resin SD-318 (produced by DAINIPPON INK KAGAKU KOGYO Co., Ltd.) and 358 parts by weight of methyl ethyl ketone were added to 100 parts by weight of acrylic resin 1BR-305 (solid contents density: 39.5wt% and produced by TAISEIKAKO Co., Ltd.). Next, using this transfer conductive film so prepared, a conductive layer was transferred to a PET film HSL 75 on which no adhesion facilitating layer was formed in the similar procedure to that of Embodiment 1. When the electric resistance of the conductive layer was measure, it was 250Ω/□ (surface resistance). When an adhesion test was carried out, 100 cells were all separated.

In the embodiment, the example was illustrated in which the transfer conductive film was prepared using the ITO fine grains, and the conductive layer was imparted to the PET film on which no adhesion facilitating layer was formed. As implemented in the embodiment, transfer functional films having various inorganic functional layers can be prepared using inorganic fine grains having various qualities. As objects to which a transfer is attempted to be made, objects can, of course, be selected which needs to be applied with the conductive layer and various types of functional layers other than the conductive layer. Due to this, the aforesaid embodiment only illustrates the example when considering from every perspective, and the invention should not be interpreted with limitation thereto. Furthermore, all modifications which belong to an equivalent scope of the claims are to fall within the scope of the invention.

## Claims

1. A transfer functional film comprising:
at least a functional layer formed on a substrate, which is separatable from the substrate, the functional layer being a compressed layer of functional fine grains; and
an adhesive layer formed on the functional layer, made up of an adhesive composition containing a curing component (A) and a polyester polyurethane resin (P).

2. A transfer functional film as set forth in Claim 1, wherein the adhesive composition contains an acrylic monomer (M) as the curing component (A).

3. A transfer functional film as set forth in Claim 1, wherein the adhesive composition contains the polyester polyurethane resin (P) and the acrylic monomer (M) in a weight ratio of P/M=2/8 to 8/2.

4. A method for forming a functional layer on a surface of an object comprising the steps of:
affixing the transfer functional film set forth in claim 1 on a surface of an object to which a functional layer is to be applied via the adhesive layer in such a manner that the substrate is positioned outside;
causing the adhesive layer to cure after the affixation; and
separating the substrate.

5. A method for forming a functional layer as set forth in Claim 4, wherein the surface of the object to which a functional layer is to be applied is not subjected an adhesion facilitate treatment.

6. A method for forming a functional layer on a surface of an object comprising the steps of:
preparing a transfer functional film having on a substrate at least a functional layer which is separatable from the substrate, the functional layer being a compressed layer of functional fine grains;
providing in advance an adhesive layer made up of an adhesive composition containing a curing component (A) and a polyester polyurethane resin (P) on a surface of an object to which a functional layer is to be applied;
affixing the transfer functional film via the adhesive layer provided in advance on the surface of the object in such a manner that the substrate is positioned outside;
causing the adhesive layer to cure after the affixation; and
separating the substrate.

7. An object in which a functional layer is applied to a surface thereof, having an adhesive layer made up of a cured material of an adhesive composition containing a curing component (A) and a polyester polyurethane resin (P) on a surface thereof and having a functional layer on the cured adhesive layer.

8. An object in which a functional layer is applied to a surface thereof as set forth in Claim 7, wherein the functional layer is a compressed layer of functional fine grains.

9. An object in which a functional layer is applied to a surface thereof as set forth in Claim 8, wherein the adhesive composition containing the curing material (A) and the polyester polyurethane resin (P) is impregnated and cured in voids among the functional fine grains in the functional layer.
